# EUROPEAN PATENT APPLICATION

(11) **EP 4 254 790 A1**
(43) Date of publication of application: **04.10.2023**
(21) Application number: 21896492.2
(22) Date of filing: 15.09.2021
(51) Int. Cl.: H03H 17/00

(54) **FILTER UNIT AND FILTER ARRAY**

(30) Priority: 30.11.2020 CN 202011381094
(71) Applicant: Sanechips Technology Co., Ltd., Shenzhen, Guangdong 518055 (CN)
(72) Inventor: WEN, Long, Shenzhen, Guangdong 518057 (CN); GONG, Xiaoliang, Shenzhen, Guangdong 518057 (CN); DU, Jinzhou, Shenzhen, Guangdong 518057 (CN)
(74) Representative: Ipsilon
(86) International application number: PCT/CN2021/118577
(87) International publication number: WO 2022/110988

(57) **Abstract**

Provided are a filter unit and a filter array, and the filter unit includes: a control module (10) configured to analyze configuration information of the filter unit, and control selection of internal functions and flow direction of data in the filter unit; a filtering module (20) connected to the control module (10), and configured to perform an operation on internal data of the filter unit and perform a sampling rate conversion function under control of the control module (10); and an output selection module (30) connected to the control module (10) and the filtering module (20), and configured to perform a selection function on output data of the filtering module (20) under control of the control module.

## Description

### CROSS-REFERENCE TO RELATED APPLICATIONS

The present disclosure is filed based on and claims the priority to Chinese Patent Application No. 202011381094.3 filed on November 30, 2020, the entire contents of which are incorporated herein by reference.

### TECHNICAL FIELD

Embodiments of the present disclosure relate to the field of signal processing, and in particular, to a filter unit and a filter array.

### BACKGROUND

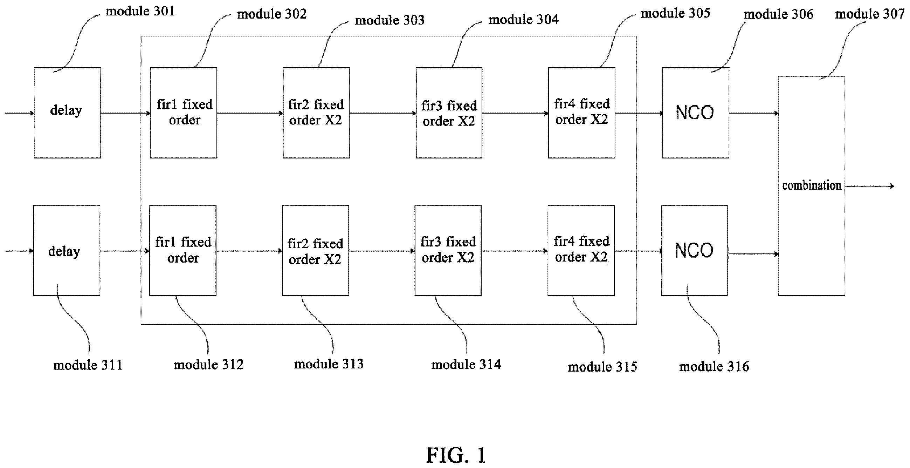

Some technical solutions to a digital filter bank are to determine an order and an interpolation/decimation multiple of each digital filter through algorithm simulation. FIG. 1 is a schematic structural diagram of a filter bank in an existing system. As shown in FIG. 1, a module 301 and a module 311 serve as delay processing units in the system, a module 306 and a module 316 serve as frequency shift processing units in the system, and a module 307 serves as a combination processing unit in the system. Modules 302, 303, 304, 305, 312, 313, 314, and 315 are different types of filter processing units with different orders.

However, the existing filter bank has the following disadvantages: after an algorithm design is completed, filter coefficient configuration can be merely realized under a condition that the orders are fixed, an operation of each module of the filter bank is independent, and sharing of calculation among the modules cannot be realized. After algorithm performance is updated, the filter bank needs to be re-developed, which prolongs a development period and increases design cost.

### SUMMARY

The embodiments of the present disclosure provide a filter unit and a filter array, so as to solve, to a certain extent, one of the existing technical problems, which include the problem that the filter tank cannot be flexibly configured and cannot be expanded due to the design of the filter bank.

An embodiment of the present disclosure provides a filter unit, including: a control module configured to analyze configuration information of the filter unit, and control selection of internal functions and flow direction of data in the filter unit; a filtering module connected to the control module, and configured to perform an operation on internal data of the filter unit and perform a sampling rate conversion function under control of the control module; and an output selection module connected to the control module and the filtering module, and configured to perform a selection function on output data of the filtering module under control of the control module.

Another embodiment of the present disclosure provides a filter array, including: a plurality of filter units described in the above embodiment, and the plurality of filter units are connected in cascade.

### BRIEF DESCRIPTION OF DRAWINGS

FIG. 1 is a schematic diagram of an implementation of a filter bank in some technical solutions;
FIG. 2 is a block diagram of a filter unit according to an embodiment of the present disclosure;
FIG. 3 is a schematic structural diagram of a filtering module according to an embodiment of the present disclosure;
FIG. 4 is a schematic structural diagram of a filter array according to an embodiment of the present disclosure;
FIG. 5 is a schematic structural diagram of a filter unit according to an embodiment of the present disclosure;
FIG. 6 is a schematic structural diagram of a filtering module according to an embodiment of the present disclosure;
FIG. 7 is a flowchart showing an implementation of interconnection of filter units according to an embodiment of the present disclosure; and
FIG. 8 is a schematic structural diagram of a filter matrix according to an embodiment of the present disclosure.

### DETAIL DESCRIPTION OF EMBODIMENTS

The embodiments of the present disclosure will be described in detail below with reference to the accompanying drawings and in conjunction with the embodiments.

It should be noted that the terms "first", "second" and the like in the description, claims, and drawings of the present disclosure are used to distinguish between similar objects, but are not necessarily used to describe a particular order or chronological order.

### First Embodiment

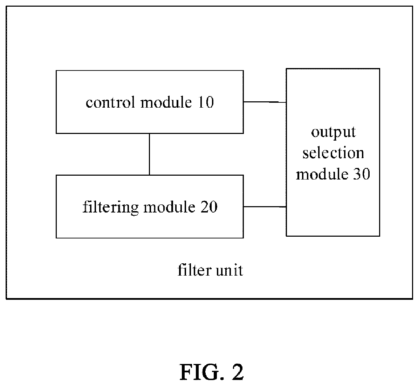

This embodiment provides a filter unit applicable to a filter. FIG. 2 is a block diagram of a filter unit according to an embodiment of the present disclosure. As shown in FIG. 2, the filter unit includes a control module 10, a filtering module 20, and an output selection module 30.

The control module 10 is configured to analyze configuration information of the filter unit, and control selection of internal functions and flow direction of data in the filter unit.

The filtering module 20 is connected to the control module 10, and is configured to perform an operation on internal data of the filter unit and perform a sampling rate conversion function under the control of the control module 10.

The output selection module 30 is connected to the control module 10 and the filtering module 20, and is configured to perform a selection function on output data of the filtering module under the control of the control module.

In this embodiment, a plurality of output selection modules 30 may be provided, and each of the output selection modules performs the selection function on the output data in a different direction.

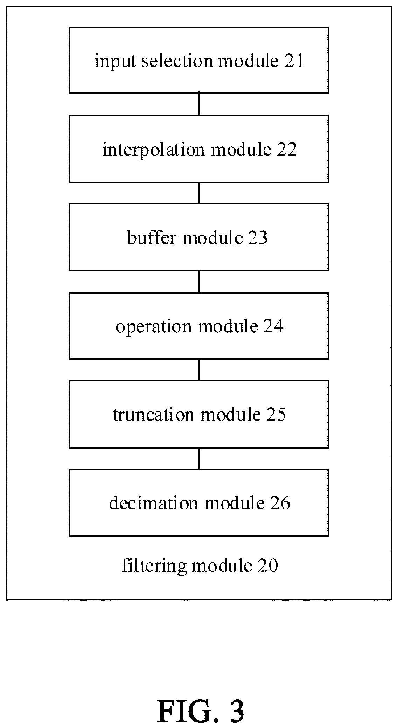

As shown in FIG. 3, in this embodiment, the filtering module 20 may include an input selection module 21, an interpolation module 22, a buffer module 23, an operation module 24, a truncation module 25, and a decimation module 26.

The input selection module 21 is configured to perform a selection function on input data of the filtering module.

The interpolation module 22 is connected to the input selection module 21, and is configured to perform an interpolation function on a sampling rate of the input data.

The buffer module 23 is connected to the interpolation module 22, and is configured to perform a data buffer function.

The operation module 24 is connected to the interpolation module 22 and the buffer module 23, and is configured to perform a data filtering operation.

The truncation module 25 is connected to the operation module 24, and is configured to perform truncation processing on an operation result output by the operation module 24.

The decimation module 26 is connected to the truncation module 25, and is configured to perform a decimation function on truncated data.

In this embodiment, a plurality of input selection modules 21 may be provided, and each of the input selection modules performs the selection function on the input data in a different direction.

In this embodiment, the control module 10 may be further configured to configure the selection function on the input data of the input selection module 21.

In this embodiment, the control module 10 may be further configured to configure an interpolation multiple of the interpolation module 22, a decimation multiple of the decimation module 26, validity of the interpolation module 22, and validity of the decimation module 26. The validity of the interpolation module 22 and the validity of the decimation module 26 are mutually exclusive at a same moment.

In this embodiment, the control module 10 may be further configured to configure a bit width of the truncation processing performed by the truncation module 25.

### Second Embodiment

An embodiment of the present disclosure further provides a filter array, including a plurality of the filter units described in the foregoing embodiment, and the filter units are connected in cascade.

In this embodiment, the plurality of the filter units may form an M×N interconnected matrix, with M and N being positive integers.

In this embodiment, at least one of the plurality of the filter units has an order different from orders of the other filter units.

In order to facilitate understanding of the technical solutions provided by the embodiments of the present disclosure, the technical solutions will be described in detail below in conjunction with embodiments of practical application scenarios.

### Third Embodiment

This embodiment provides a filter matrix device formed by interconnecting standard digital filter units; and through interconnection configuration of the standard digital filter units, cascade connection of multiple filter banks may be realized or one or more high-order filters may be formed through combination of the multiple filter banks, thereby completing up-sampling or down-sampling of input data, realizing any high-order filter, and completing online configuration of a filter coefficient. Such design of the standard digital filter units can greatly reduce a design period of a project, and meanwhile, the standard digital filter units can be reconfigured according to system requirements to meet new function and performance requirements after the design of the project is finished.

As shown in FIG. 1, the module 301 and the module 311 serve as the delay processing units in the existing system, the module 306 and the module 316 serve as the frequency shift processing units in the existing system, the module 307 serves as the combination processing unit in the existing system, but those modules are not the objects to be replaced according to the embodiments of the present disclosure. The modules 302, 303, 304, 305, 312, 313, 314, and 315 are different types of filter processing units with different orders, and can be replaced with the filter unit provided by this embodiment, so as to improve flexibility and extensibility of a design scheme of the existing filter bank.

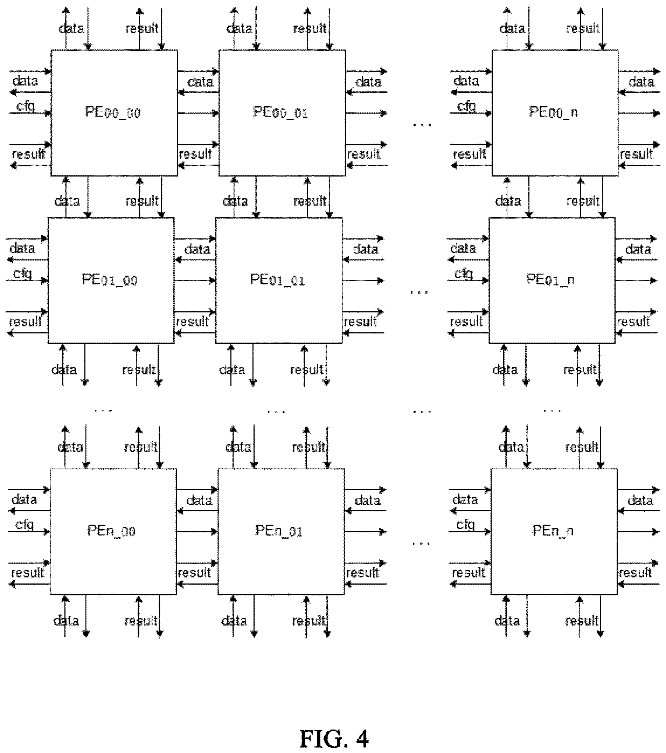

It should be noted that division and functions of the modules in this embodiment are not exactly the same as those in the foregoing embodiments. As shown in FIG. 4, the filter matrix device provided by this embodiment is formed by interconnecting a plurality of identical standard filter units 601.

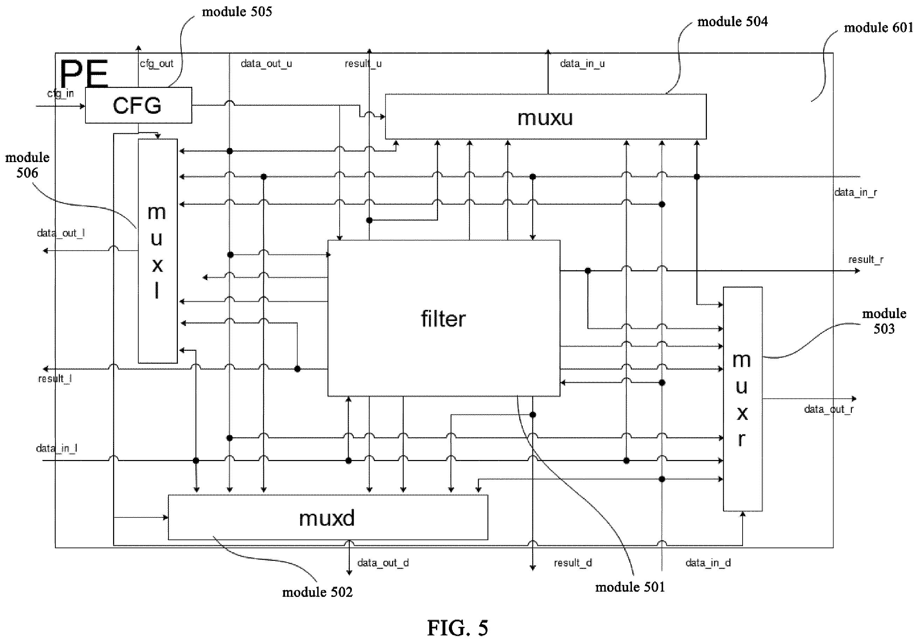

FIG. 5 is a block diagram of an implementation of the standard filter unit 601 according to an embodiment of the present disclosure. As shown in FIG. 5, the standard filter unit may include the following functional modules 505, 506, 504, 503, 502, and 501.

The module 505 is configured to analyze current standard filter configuration information, and control selection of internal functions and flow direction of a data link in the filter unit 601.

The modules 506, 504, 503, and 502 are configured to perform output data selection functions in four directions for realizing data interaction of cascaded modules, and the four output data selection modules may be independently configured through the module 505. Meanwhile, the output data selection functions may be expanded to any number, which merely needs several copies of the module 506, so as to deal with scenarios with complex data path mapping.

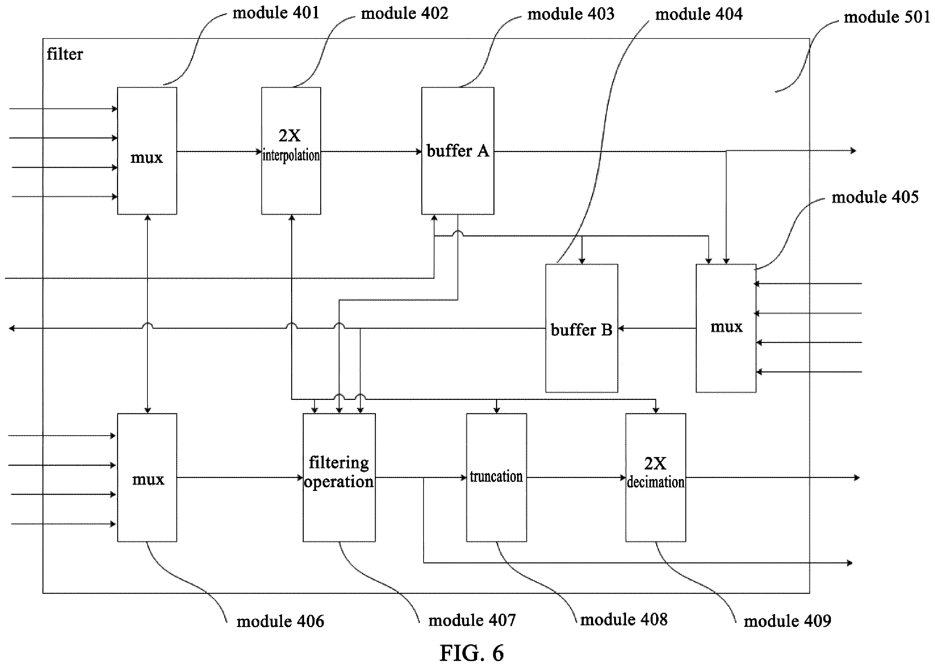

The module 501 is configured to perform an operation on internal data of a filter and perform a sampling rate conversion function, and reference may be made to FIG. 6. for a specific implementation of the module 501.

FIG. 6 is a block diagram showing a design of a filtering module according to an embodiment of the present disclosure. As shown in FIG. 6, the filtering module may include the following functional modules 401, 402, 403, 405, 404, 406, 407, 408, 409.

The module 401 is configured to perform an input data selection function; and the function may be configured through the module 505.

The module 402 is configured to perform a 2x interpolation function on a sampling rate of the input data; and the function may be configured through the module 505.

The module 403 is configured to perform a data buffer function for an operation performed by the module 407.

The module 405 is configured to perform a buffer function on input data of the module 404, and an input to the module 404 may be input data from the module 403 or the module 601 in four directions, and the function may be configured through the module 505.

The module 404 is configured to perform a data buffer function for an operation performed by the module 407.

The module 406 is configured to perform a selection function on cascade results input in the four directions of the filter unit 601; and the function may be configured through the module 505.

The module 407 is configured to perform a data operation and accumulate output results of the module 406, and may directly output a result to the four directions of the module 601.

The module 408 is configured to perform truncation processing on an operation result of the module 407, and a bit width of the truncation processing may be configured through the module 505.

The module 409 is configured to perform a 2x decimation function on truncated data, and the function may be configured through the module 505; and the 2x decimation function and the function of the module 402 are mutually exclusive and cannot be configured to be effective at the same time.

It should be noted that each of the above modules may be implemented as software or hardware, and the following methods may be adopted when each module is implemented as hardware, but the implementation as hardware is not limited to the following methods: all the modules may be located in a same processor; or the modules may be randomly combined and located in different processors.

In this embodiment, the filter matrix device may be formed by interconnecting the standard filter units, and the implementation is simple and merely needs to interconnect the filter units 601 according to estimated resources.

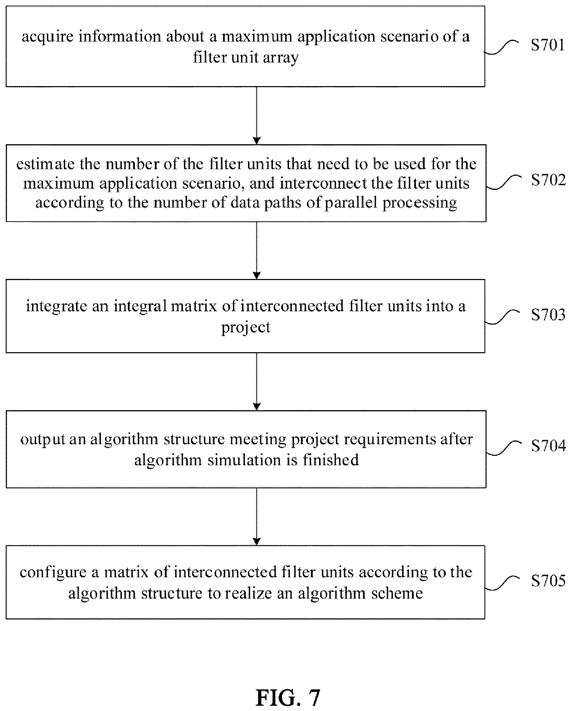

A method for implementing the filter matrix device is described below. As shown in FIG. 7, the method may include the following operations: operation S701, acquiring information about a maximum application scenario of a filter unit array provided by this embodiment; operation S702, estimating the number of the filter units provided by this embodiment that need to be used for the maximum application scenario, and reasonably interconnecting the filter units according to the number of data paths of parallel processing; operation S703, integrating an integral matrix of interconnected filter units into a project; operation S704, outputting an algorithm structure meeting project requirements after algorithm simulation is finished; and operation S705, configuring a matrix of interconnected filter units according to the algorithm structure to realize an algorithm scheme.

Through the above description of the implementations, those of ordinary skill in the art can clearly understand that the method according to the above embodiment may be implemented by software together with a necessary general-purpose hardware platform.

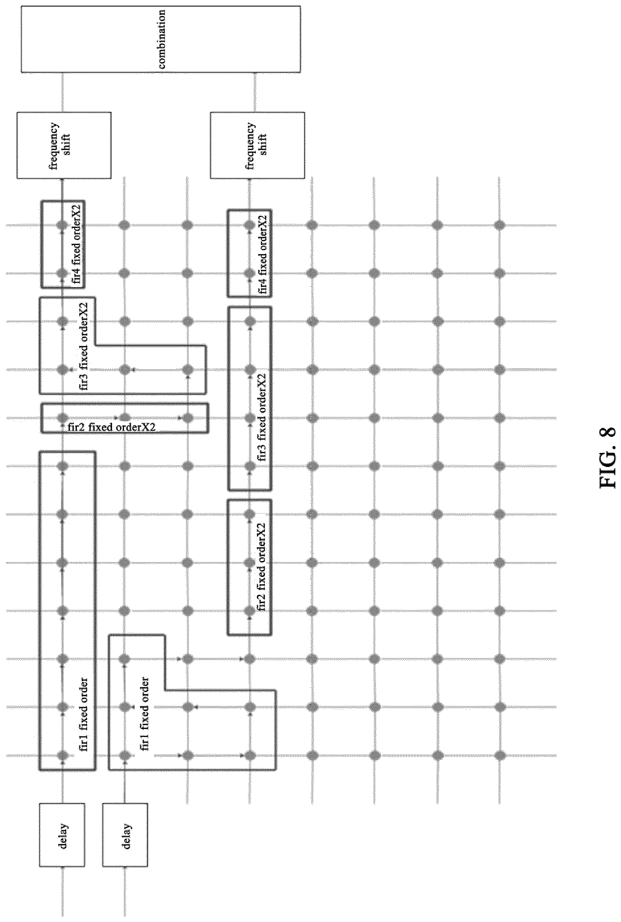

FIG. 8 is a schematic structural diagram of an 8×12 interconnected matrix formed according to an embodiment of the present disclosure. As shown in FIG. 8, in this embodiment, any number of filter processing units in the existing system may be replaced, and positions of the filter processing units in the existing system may be arbitrarily changed, or the orders of the filter processing units in the existing system may be updated to meet new algorithm performance requirements.

In the above embodiments of the present disclosure, the standard filtering unit provided can directly replace the filtering processing unit of the existing filter bank, and flexibility and extensibility of the existing filter bank can be greatly improved. The order of the filter can be flexibly configured, without being limited by the algorithm design; and cascade connection of a plurality of filter modules can be realized, an order of each of the filter modules can be flexibly configured, up-sampling and down-sampling can be flexibly supported, and multi-path expansion of data can be supported.

In the above embodiments of the present disclosure, by interconnecting the filter units to form the filter matrix, flexibility and expandability of configuration of the existing filter bank are greatly improved, so that the order of the filter can be flexibly configured, without being limited by the algorithm design, and the multi-path expansion of data can be supported.

Apparently, it should be understood by those of ordinary skill in the art that all the modules or operations of the present disclosure described above may be implemented by a general-purpose computing device, may be integrated in a single computing device or distributed on a network composed of a plurality of computing devices. The modules or operations may be implemented by program codes executable by a computing device, so that the modules or operations can be stored in a storage device and executed by the computing device. In some cases, the operations illustrated or described may be performed in an order different from that described herein. The modules or operations may be separately made into integrated circuit modules, or some of the modules or steps may be made into a single integrated circuit module. Thus, the present disclosure is not limited to any specific combination of hardware and software.

The description above is merely of some embodiments of the present disclosure, but is not intended to limit the present disclosure. Various modifications and changes may be made to the present disclosure by those of ordinary skill in the art. Any modification, equivalent replacement and improvement made within the principle of the present disclosure should be included in the scope of the present disclosure.

## Claims

1. A filter unit, comprising:
a control module configured to analyze configuration information of the filter unit, and control selection of internal functions and flow direction of data in the filter unit;
a filtering module connected to the control module, and configured to perform an operation on internal data of the filter unit and perform a sampling rate conversion function under control of the control module; and
an output selection module connected to the control module and the filtering module, and configured to perform a selection function on output data of the filtering module under control of the control module.

2. The filter unit of claim 1, wherein the output selection module comprises a plurality of output selection modules, each of the output selection modules performing the selection function on the output data in a different direction.

3. The filter unit of claim 1, wherein the filtering module comprises:
an input selection module configured to perform a selection function on input data of the filtering module;
an interpolation module connected to the input selection module, and configured to perform an interpolation function on a sampling rate of the input data;
a buffer module connected to the interpolation module, and configured to perform a data buffer function;
an operation module connected to the interpolation module and the buffer module, and configured to perform a data filtering operation;
a truncation module connected to the operation module, and configured to perform truncation processing on an operation result output by the operation module; and
a decimation module connected to the truncation module, and configured to perform a decimation function on truncated data.

4. The filter unit of claim 3, wherein the input selection module comprises a plurality of input selection modules, each of the input selection modules performing the selection function on the input data in a different direction.

5. The filter unit of claim 3, wherein the control module is further configured to configure the selection function of the input selection module.

6. The filter unit of claim 3, wherein the control module is further configured to configure an interpolation multiple of the interpolation module, a decimation multiple of the decimation module, validity of the interpolation module, and validity of the decimation module, wherein the validity of the interpolation module and the validity of the decimation module are mutually exclusive at a same moment.

7. The filter unit of claim 3, wherein the control module is further configured to configure a bit width of the truncation processing performed by the truncation module.

8. A filter array, comprising a plurality of filter units of any one of claims 1 to 7, wherein the plurality of filter units are connected in cascade.

9. The filter array of claim 8, wherein the plurality of filter units form an M× N interconnected matrix, M and N being positive integers.

10. The filter array of claim 8, wherein at least one of the plurality of filter units has an order different from orders of other filter units of the plurality of filter units.
